# EUROPÄISCHE PATENTSCHRIFT

(11) **EP 1 161 573 B1**
(45) Veröffentlichungstag und Bekanntmachung des Hinweises auf die Patenterteilung: **04.09.2002**
(21) Anmeldenummer: 99963268.0
(22) Anmeldetag: 30.11.1999
(51) Int. Cl.: C23C 16/30, C23C 30/00, B23B 27/00

(54) **WERKZEUG MIT EINER MOLYBDANSULFIDSCHICHT UND VERFAHREN ZU DESSEN HERSTELLUNG**
TOOL WITH A MOLYBDENUM SULPHIDE COATING AND METHOD FOR PRODUCING THE SAME
OUTIL PRESENTANT UNE COUCHE DE SULFURE DE MOLYBDENE ET SON PROCEDE DE PRODUCTION

(30) Priorität: 03.03.1999 DE 19909372
(43) Veröffentlichungstag der Anmeldung: 12.12.2001
(73) Patentinhaber: Widia GmbH, 45145 Essen (DE)
(72) Erfinder: KÖNIG, Udo, D-45149 Essen (DE); SOTTKE, Volkmar, D-45479 Mülheim (DE); LEONHARDT, Albrecht, D-01326 Dresden (DE); ENDLER, Ingolf, D-01640 Coswig (DE)
(74) Vertreter: Vomberg, Friedhelm, Dipl.-Phys.
(86) Internationale Anmeldenummer: DE9903781
(87) Internationale Veröffentlichungsnummer: WO00052222

(56) Entgegenhaltungen:
- EP-A- 0 534 905
- DE-A- 3 834 356
- DE-A- 19 825 572
- US-A- 2 671 739

## Beschreibung

Die Erfindung betrifft ein Werkzeug, insbesondere einen Schneideinsatz zum Zerspanen von metallischen Werkstoffen, aus einem Hartmetall-, Cermet-, Keramik- oder Stahlgrundkörper und mindestens einer hierauf abgeschiedenen Schicht, wovon die einzige Schicht oder bei mehreren Schichten die äußere oder die unter einer äußeren Schicht liegende Schicht im wesentlichen aus Molybdänsulfid besteht.

Die Erfindung betrifft ferner ein Verfahren zur Herstellung der Molybdänsulfidschicht mittels CVD.

Die Beschichtung von Substratkörpern aus Hartmetall, einem Cermet, einer Keramik oder Stahl mit Hartstoffen oder Hartstoffmischungen oder Keramikwerkstoffen ist nach dem Stand der Technik bekannt. Insbesondere werden Carbide, Nitride, Carbonitride, Oxicarbonitride, Oxide und/oder Boride mindestens eines der Elemente der IVa- bis VIa-Gruppe des Periodensystemes, wie beispielsweise TiC, TiN, Ti(C,N), oder auch keramische Werkstoffe wie Al₂O₃ oder ZrO₂ verwendet. Bei großen Schnittgeschwindigkeiten und/oder großen Spanungsquerschnitten entstehen mitunter insbesondere bei schwer zerspanbaren Werkstoffen hohe Temperaturen an der Schneide des Zerspanungswerkzeuges, die wiederum einen erhöhten Verschleiß, zum Teil auch Kantenausbrüche zur Folge hatten. Um die beim Zerspanen an der Werkzeugschneide auftretenden Temperaturen zu minimieren, werden daher üblicherweise sogenannte Kühlschmierstoffe verwendet, die jedoch umwelt- und gesundheitsgefährdende Substanzen enthalten und unter Aufwendung hoher Kosten entsorgt werden müssen.

Eine weitere Möglichkeit, den Einsatz von Kühlschmierstoffen drastisch zu vermindern, ist das Prinzip der sogenannten Minimalmengenschmierung, wobei sehr geringe Mengen von Kühlschmierstoffen punktgenau durch feine Kanäle an die Kontaktstelle zwischen der Werkzeugschneide und dem Werkstückstoff gebracht werden. Abgesehen von einem hohen verfahrenstechnischen und apparativen Aufwand wird durch diese Maßnahme das Entsorgungsproblem nicht beseitigt, sondern lediglich minimiert.

Andererseits sind nach dem Stand der Technik sogenannte Feststoff-Trockenschmierfilme, z.B. aus Molybdändisulfid beispielsweise aus der DE-A-24 15 255 bekannt, worin vorgeschlagen wird, zur Erhöhung der Haftung auf Lagerflächen durch das sogenannte Sputtern eine vorzugsweise aus MoS₂ oder WS₂ bestehende Grundierschicht mit einer Dicke von 1 bis 2 µm aufzutragen und daß das Aufbringen der eigentlichen vorzugsweise ebenfalls aus MoS₂ oder WS₂ bestehenden Trockenschmierschicht auf die Grundierschicht in bekannter Weise durch polierendes Auftragen erfolgen soll.

In der DD 202 898 wird vorgeschlagen, auf Schnitt-, Stanz-, Zieh- und Zerspanungswerkzeuge, Lagern oder ähnlichem Molybdändisulfid durch Sputtern aufzutragen, wobei sich die Schichtdicke im nm-Bereich bewegen soll. Die auf einen mit einer Hartstoffschicht versehenen Substratkörper durch Sputtern aufgetragene Schicht soll eine hexagonale Gitterstruktur aufweisen. Auch die EP 0 534 905 A2 schlägt die PVD-Beschichtung von Zerspanungswerkzeugen u.a. mit Molybdändisulfid vor.

Es hat sich jedoch herausgestellt, daß durch Kathodenzerstäubung (Sputtern) hergestellte MoS₂-Schichten schlecht auf dem Substratkörper oder auf der äußeren, auf den Substratkörper aufgetragenen Hartstoffschicht haften oder häufig eine ungünstige Orientierung der MoS₂-Kristallite aufweisen. Um niedrige Reibungskoeffizienten zu erhalten, sollten die hexagonalen Bestandteile der MoS₂-Schicht so ausgerichtet sein, daß die hexagonalen Basisebenen parallel zur Oberfläche liegen. Dadurch wird auch die Oxidationsbeständigkeit der Schicht verbessert.

In der DE 35 16 933 A1 ist daher vorgeschlagen worden, das Verhältnis des Wasserdampfpartialdruckes zur Beschichtungsrate kleiner als 10⁻⁷ mbar/1.6 mgm⁻²s⁻¹ einzustellen, was in der Praxis nur mit großem technischen Aufwand erreichbar ist. Neben der im übrigen bei den PVD-Verfahren notwendigen reinen, d.h. nicht mit Fremdstoffen belasteten Gasatmosphäre liegt ein weiterer Nachteil bei den PVD-Verfahren darin, daß ein gerichteter Teilchenstrom von der Targetquelle zu den Substraten vorliegt, weshalb die Substrate zur Herstellung einer gleichmäßigen Beschichtung um drei Achsen gedreht werden müssen.

Weiterhin beschreibt die WO 97/04142 ein Verfahren zur gleichzeitigen Abscheidung von MoS₂ und einem Metall oder einer Metallverbindung wie Titan oder Titannitrid unter Verwendung von zwei Targets mittels eines Sputter-Verfahrens.

Obwohl das MoS₂ relativ weich und nicht besonders abriebfest ist, erzielen MoS₂-Schichten eine beachtliche Wirkung, da beim Einsatz einer solchen einzigen oder äußeren MoS₂-Schicht zwar an der Kontaktstelle des Werkzeuges mit dem Werkstück das MoS₂ rasch abgerieben wird, jedoch die Reibungskräfte durch ein Eindringen von MoS₂-Partikeln vom Rande her (Entrainment) noch eine Weile merklich vermindert werden.

Es ist Aufgabe der vorliegenden Erfindung, eine einzige oder äußere Schicht bzw. Schichtkombination anzugeben, die ein dichtes Gefüge, eine höhere Härte und eine hohe mechanische Stabilität gegen Abrieb aufweist. Ferner ist es Aufgabe, ein Verfahren zur Herstellung einer solchen Schicht anzugeben.

Diese Aufgabe wird durch ein Werkzeug nach Anspruch 1 gelöst, das dadurch gekennzeichnet ist, daß die Molybdänsulfidschicht ein Gemisch der Sulfidphasen MoS₂ und Mo₂S₃ mit einer im wesentlichen regellosen Orientierung der Phasenkristalle enthält. Das Schichtgefüge besteht aus regellos orientierten MoS₂-Körnern, die teilweise eine plättchenförmige Gestalt haben. Die Zwischenräume sind mit Mo₂S₃-Phasen ausgefüllt. Durch diese Maßnahme ergibt sich überraschenderweise eine verbesserte Abriebbeständigkeit der Schichten beim Zerspanen.

Weiterbildungen des Werkzeuges sind in den Unteransprüchen beschrieben.

So können in der Molybdänsulfidschicht noch weitere Phasen aus Molybdän, Schwefel und/oder Chlor enthalten sein, die jedoch jeweils 6 Atom% nicht übersteigen sollen.

Die einzige oder die äußere Molybdänsulfidschicht kann auch mehrlagig ausgebildet sein, wobei die jeweils unterste Lage oder die untersten Lagen mit einer jeweils 200 nm nicht übersteigenden Dicke eine hexagonale Gitterstruktur mit einer Vorzugsorientierung der hexagonalen Ebenen parallel zur Werkzeugoberfläche aufweisen. Die übrigen Lagen besitzen jedoch die isotrope Orientierung. Dies gilt insbesondere für einen Substratkörper, der nur mit einer einzigen Molybdänsulfidschicht (und keiner anderen Schicht) beschichtet ist. Die Lage mit den hexagonalen MoS₂-Kristalliten grenzt unmittelbar an die Substratunterlage an und hat eine Dicke von 100 nm bis 200 nm.

Nach einer weiteren Ausgestaltung der Erfindung ist der Mo₂S₃-Anteil in der Molybdänschicht nicht gleichbleibend homogen, sondern mit wachsendem Abstand von der Substratkörperoberfläche unterschiedlich groß, vorzugsweise ändert er sich periodisch von 5 bis 30 Vol.%.

Nach einer weiteren Ausgestaltung der Erfindung enthält die Molybdänsulfidschicht aufeinanderfolgende einzelne Lagen unterschiedlicher Zusammensetzung, wovon die eine Sorte aus dem Gemisch der Sulfidphasen MoS₂ und Mo₂S₃ besteht und die andere im wesentlichen aus reinem MoS₂. Jede der MoS₂-Lagen hat eine maximale Dicke von 200 nm. Die Dicke der Lagen aus dem genannten Phasengemisch (MoS₂/Mo₂S₃) liegt jeweils zwischen 200 nm und 400 nm.

In einer weiteren Ausführungsform des erfindungsgemäßen Werkzeuges sind in der betreffenden Molybdänsulfidschicht noch weitere metallische Phasen und/oder Hartstoffphasen enthalten, deren Volumenanteil jedoch 10 Vol.% vorzugsweise nicht übersteigen sollte. Als Metall kommt insbesondere Molybdän, als Hartstoff insbesondere Molybdäncarbid, Titancarbonitrid oder Chromcarbid in Frage. Solche Metall- oder Hartstoffphasen dienen zur Erhöhung der Stabilität dieser Schicht, die jedoch im wesentlichen Molybdänsulfid der eingangs genannten Mischung enthält. Der Volumenanteil an MoS₂ in dieser Schicht liegt zwischen 30 und 98 Vol.%, vorzugsweise zwischen 40 und 95 Vol.%. Die Schichtdicke liegt zwischen 0,5 bis 8 µm, vorzugsweise zwischen 2 und 4 µm.

Gegebenenfalls kann auch auf die einzige oder die äußere Schicht aus Molybdänsulfid noch eine weitere Metallschicht einer Dicke ≤ 200 nm aufgetragen sein, wobei vorzugsweise Metalle der IVa- bis VIa-Gruppe des Periodensystemes verwendet werden. Alternativ kann diese dünne äußere maximal 200 nm dicke Lage auch aus einem Hartstoff, vorzugsweise einem Carbid, einem Nitrid oder einem Carbonitrid eines der vorgenannten Elemente bestehen.

Die Molybdänsulfidschicht wird mittels eines CVD-Verfahrens aufgetragen, vorzugsweise unter Verwendung der nachfolgend beschriebenen Verfahrenstechnik.

Zur Herstellung der genannten Beschichtung wird ein CVD-Verfahren verwendet, wobei das Gasgemisch aus Molybdänchlorid, Schwefelwasserstoff, einem Edelgas und Wasserstoff besteht und die Beschichtungstemperaturen zwischen 500°C und 900°C, vorzugsweise zwischen 600°C und 850°C, liegen. Der Druck beträgt 0,1 bis 50 kPa, vorzugsweise liegt er zwischen 0,1 und 1 kPa. Das Molverhältnis zwischen Schwefelwasserstoff und Molybdänchlorid liegt zwischen 0,1 und 4, vorzugsweise zwischen 0,1 und 2. Der gemeinsame Anteil an Wasserstoff und Argon liegt zwischen 80 bis 99 Vol.%, vorzugsweise zwischen 90 bis 98 Vol.%.

Vorzugsweise wird MoCl₅ verwendet, ggf. können auch MoCl₄ oder Mischungen aus MoClₛ und MoCl₄ verwendet werden.

Die Einhaltung der obengenannten Parameter ist entscheidend für die Herstellung der im wesentlichen Molybdänsulfid enthaltenden Schicht. Bei größeren als den vorbeschriebenen Molverhältnissen werden Schichten erhalten, die nur oder zum weitaus überwiegenden Teil aus hexagonalem MoS₂ bestehen. MoCl₅ kann bei Temperaturen über 200°C in MoCl₄ und Cl zerfallen, so daß die Molybdänsulfide sowohl aus MoCl₅ als auch aus MoCl₄ gebildet werden können.

Die Mischschichten, die hexagonales MoS₂ und Mo₂S₃ enthalten, können einerseits als Schicht mit konstantem Mo₂S₃-Anteil und regelloser Orientierung der MoS₂-Kristallite hergestellt werden. Andererseits lassen sich mit dem erfindungsgemäßen Verfahren auch mehrlagige Schichten herstellen, die im Wechsel aus Lagen mit MoS₂/Mo₂S₃-Phasengemischen und Lagen aus orientiertem MoS₂ bestehen. Im letztgenannten Fall darf die MoS₂-Lage jedoch nicht dicker als 200 nm sein, weil sonst in der Molybdänsulfidschicht Poren entstehen, womit deren Dichte abnimmt. In einem speziellen Ausführungsbeispiel ist das Molverhältnis H₂S/MoCl₅ während der Beschichtung alternierend für jeweils gleich lange Zeiträume, in denen eines der wählbaren Molverhältnisse eingestellt ist, um einen Faktor 7 bis 10 vergrößert worden, so daß bei größerem Molverhältnis reines MoS₂ und bei kleinem Molverhältnis ein Phasengemisch aus MoS₂ und Mo₂S₃ abgeschieden wird. Die Zeitdauer, während der im wesentlichen reines MoS₂ abgeschieden wird, ist zum einen durch die maximal zulässige Lagendicke von 200 nm vorgegeben. Demgegenüber ist die Zeitdauer, während der durch Einstellung des Molverhältnisses im wesentlichen das Phasengemisch MoS₂/Mo₂S₃ abgeschieden wird, zwei- bis dreimal so groß. Vorzugsweise werden acht bis zwölf Lagen abgeschieden, wovon jeweils die Hälfte aus dem genannten Phasengemisch und die andere Hälfte aus MoS₂ bestehen.

Alternativ hierzu kann das Molverhältnis H₂S/MoCl₅ auch derart gesteuert werden, daß bei der Abscheidung der Mo₂S₃-Phasenanteil periodisch schwankt.

Die Molybdänsulfidschicht besteht im wesentlichen aus hexagonalem MoS₂ und Mo₂S₃, kann jedoch noch weitere Phasen enthalten, die sich aus dem Gasgemisch aus MoCl₅, H₂S, H₂ und Argon ebenfalls bilden können. So treten bisweilen geringe Anteile von rhomboedrischem MoS₂, MoS₂Cl₂ und MoCl₃ auf, die jedoch keinen merklichen Einfluß auf die Schichteigenschaften haben.

Die im wesentlichen aus Molybdänsulfid bestehende Schicht kann auch mehrlagig ausgebildet sein, wobei die einzelnen, im wesentlichen MoS₂ und Mo₂S₃ enthaltenen Lagen durch Zwischenlagen aus einem Metall oder einem metallischen Hartstoff unterteilt sind. Die Zwischenlage ist jedoch stets dünner als 0,3 µm. Als Material für solche Zwischenlagen kommen Molybdän oder Molybdäncarbid in Betracht, welche die mechanische Stabilität der erfindungsgemäßen Molybdänsulfidschicht erhöhen. Um Molybdän oder Molybdäncarbid abzuscheiden, wird in dem CVD-Verfahren die Gasgemisch-Zusammensetzung dergestalt geändert, daß die Zufuhr von H₂S unterbrochen und durch CH₄ ersetzt wird. Ebenso ist es durch schnelles Umschalten der Gase möglich, quasi kontinuierliche Schichten zu erhalten, die neben MoS₂ und Mo₂S₃ noch andere Phasen enthalten. Auch durch diese Maßnahme läßt sich die Stabilität der Trockenschmierstoffschicht verbessern. In der Praxis wird jeweils abzuwägen sein, welchen Anteil die stabilitätserhöhenden, nichtsulfidischen Beimengungen oder Zwischenschichten haben sollen. Die niedrigsten Reibbeiwerte erhält man mit Schichten, die aus hexagonalem MoS₂ bestehen, jedoch kann durch die zusätzliche Mo₂S₃-Phase die Stabilität und weiterhin durch nichtsulfidische Beimengungen erhöht werden. Die Wahl der jeweiligen Anteile an stabilitätserhöhenden Verbindungen und/oder Metallen bzw. Hartstoffen hängt von der Art des zu bearbeitenden Werkstückstoffes und den beim Zerspanen auftretenden Schnittkräften ab.

Die Erfindung wird im folgenden an konkreten Ausführungsbeispielen weiter erläutert:

### Ausführungsbeispiel 1

Es wurde eine CVD-Apparatur mit einem beheizbaren Quarzglasrohr als Reaktionskammer benutzt. Das MoCl₅-Gas wurde durch Verdampfung von MoCl₅-Salz bei 110°C in einem Argonstrom erzeugt und der auf 650°C erwärmten Reaktionskammer zugeführt. In einer zweiten Leitung wurden die anderen Gase eingespeist. Die Gasmischung bestand aus 0.4 Vol.% H₂S, 2.2 Vol.% MoCl₅, 14.6 Vol.% H₂ und 82.8 Vol.% Ar. Das Molverhältnis H₂S/MoCl₅ beträgt 0.18. Während der Beschichtung wurde in der Reaktionskammer ein Druck von 500 Pa aufrechterhalten. In der Kammer befanden sich unbeschichtete und mit Titannitrid/Titancarbonitrid/Titannitrid beschichtete Wendschneidplatten und dünne Siliziumscheiben für analytische Untersuchungen. Nach einer Beschichtungsdauer von 150 Minuten hatte sich Schichten von etwa 3 bis 4 µm Dicke mit sehr dichtem Gefüge gebildet. Durch Phasenanalysen mittels Röntgenbeugung und Elektronenbeugung wurden hexagonales MoS₂ und Mo₂S₃ gefunden.

Das mengenmäßige Verhältnis von beiden Phasen kann aus Aufnahmen, die beide Phasen sichtbar machen, nur verhältnismäßig grob abgeschätzt werden. Der Volumenanteil der hexagonalen MoS₂-Phase beträgt im vorliegenden Fall etwa 60%. Die relativ dicke Schicht ist haft- und kratzfest. Die Vickershärte betrug 400 HV0₂. Im tribologischen Test wurde ein Reibungskoeffizient von 0.11 gefunden (gegen eine Stahlkugel).

### Ausführungsbeispiel 2

In einem anderen Versuch mit der oben beschriebenen Apparatur wurden zwei Gasmischungen im Wechsel eingestellt, wobei das Molverhältnis H₂S/MoCl₅ um den Faktor 10 geändert wird. Zu Versuchsbeginn wird eine Gasmischung aus 0.2 Vol.% H₂S, 0.9 Vol.% MoCl₅, 14.8 Vol.% H₂ und 84.1 Vol.% Ar eingeleitet. Die Abscheidungstemperatur ist 670°C und der Druck 500 Pa. Bei diesen Bedingungen wird ein Phasengemisch aus hexagonalem MoS₂ und Mo2S3 abgeschieden. Nach 5 Minuten wird der H₂S-Gasstrom um das zehnfache erhöht, bei Konstanz aller anderen Gase. Die neue Gasmischung von 1.8 Vol.% H₂S, 0.9 Vol.% MoCl₅, 14.6 Vol.% H₂ und 82.7 Vol.% Ar wird dem Reaktor zwei Minuten lang zugeführt. Unter diesen Bedingungen wird weitgehend reines MoS₂ abgeschieden. Der Wechsel zwischen beiden Gasmischungen erfolgte jeweils zehnmal. Mit den Umschaltezeiten betrug die gesamte Beschichtungszeit etwa 80 Minuten. Es wurde eine dichte Schicht mit einer Dicke von 3,2 µm erhalten. Im Röntgendiffraktogramm ist zu erkennen, daß die Intensität des 002-Reflexes des hexagonalen MoS₂ erheblich stärker als im 1. Ausführungsbeispiel ausgeprägt ist. Dies deutet daraufhin, daß mehr mit der hexagonalen Achse parallel zur Oberflächennormale gerichtete Anteile von MoS₂ vorhanden sind. Die Ursache für diese Beobachtung sind die Texturen der einphasigen MoS₂-Schichten.
Die Vickers-Härte der Schicht beträgt 380 HV02 und der Reibungskoeffizient 0.08.

### Ausführungsbeispiel 3

Es wird eine Temperatur von 800°C und ein Druck von 500 Pa eingestellt und ein Gasgemisch aus 0.4 Vol.% H₂S, 2.2 Vol.% MoCl₅, 54.2 Vol.% H₂ und 43.2 Vol.% Ar zugeführt. Nach 5 Minuten wird das H₂S abgestellt, alle übrigen Parameter jedoch unverändert gelassen. Aus MoCl₅, H₂ und Ar bildet sich nun innerhalb von fünf Minuten eine dünne Schicht aus Molydänmetall. Diese beiden Schritte werden zehnmal wiederholt. Nach 110 Minuten hat sich eine ca. 4 µm dicke Schicht mit den Phasen MoS₂ und Mo₂S₃ gebildet, die einen erhöhten Molydängehalt und ein dichtes Gefüge aufweist. Der Härtewert der Schicht beträgt 520 HV02, der Reibungskoeffizient 0.14.

### Ausführungsbeispiel 4

Versuchsdurchführung wie in Ausführungsbeispiel 3, jedoch wird im zweiten Schritt Methan anstelle von H₂S zugeführt: 6.9 Vol.% CH₄, 1.8 Vol.% MoCl₅, 55.3 Vol.% H₂ und 36.0 Vol.% Ar. Diese Variante führt zur Bildung von dünnen Zwischenschichten aus Mo₂C. Der Härtewert der Schicht beträgt 530 HV02, der Reibungskoeffizient 0.18.

Zur Erprobung der Trockenschmierstoffschichten wurden handelsübliche Wendeschneiplatten der Form CNMG120412 verwendet, die aus einer Hartmetalllegierung aus 6% Co, 8% (Ti,Ta,Nb)C und 86% WC bestehen. Die Platten waren mit einer ca. 12 µm dicken Beschichtung aus den drei Lagen TiN, Ti(C,N) und TiN versehen, die in einer CVD-Produktionsanlage bei ca. 1000°C aufgetragen wurde. Solche Platten wurden in der oben beschriebenen Versuchsanlage zusätzlich mit den erfindungsgemäßen Beschichtungen überzogen. Für die Versuche wurden Exemplare mit annähernd gleichen Dicken (3 µm) der äußeren MoS₂/Mo₂S₃-Schichten herausgesucht. Mit diesen Wendeschneidplatten wurde eine Welle aus rostfreiem Stahl solange durch Drehen im glatten Schnitt bearbeitet, bis die Schneidecke durch Verschleiß oder Ausbrüche unbrauchbar wurde. Die Drehversuche wurden im Trockenschnitt mit Schnittgeschwindigkeiten von 200 m/min, Schnittiefen von 2.5 mm und einem Vorschub von 0.25 mm/Umdrehung ausgeführt. Dabei wurden folgende Resultate erhalten:
Schneidkörper CNMG120412,
beschichtet mit TiN/Ti(C,N)/TiN

| Ausführung | Dicke der MoS2/Mo2S3-haltigen Schicht | Standzeit (Minuten) |
|---|---|---|
| ohne erfindungsgemäße äußere Schicht | 0 µm | 9 |
| | | |
| Trockenschmierstoffschicht nach Ausführungsbeispiel 1 | 3.0 µm | 17 |
| | | |
| Trockenschmierstoffschicht nach Ausführungsbeispiel 2 | 3.2 µm | 19 |
| | | |
| Trockenschmierstoffschicht nach Ausführungsbeispiel 3 | 3.2 µm | 16 |
| | | |
| Trockenschmierstoffschicht nach Ausführungsbeispiel 3 | 2.9 µm | 15 |

Diese Resultate zeigen, daß alle Varianten der erfindungsgemäßen Beschichtung die Standzeit bei der Trockenbearbeitung erheblich verlängern.

## Patentansprüche

1. Werkzeug, insbesondere Schneideinsatz zum Zerspanen von metallischen Werkstoffen, aus einem Hartmetall-, Cermet-, Keramik- oder Stahlgrundkörper und mindestens einer hierauf abgeschiedenen Schicht, wovon die einzige Schicht oder bei mehreren Schichten die äußere oder die unter einer äußeren Schicht liegende Schicht im wesentlichen aus Molybdänsulfid besteht,
**dadurch gekennzeichnet,**
**daß** die Molybdänsulfidschicht ein Gemisch der Sulfidphasen MoS₂ und Mo₂S₃ mit im wesentlichen regelloser Orientierung (isotrope Orientierung) der Phasenkristalle enthält.

2. Werkzeug nach Anspruch 1, **dadurch gekennzeichnet, daß** in der Molybdänsulfidschicht noch weitere Molybdän-, Schwefel- und/oder Chlor-enthaltende Phasen vorliegen.

3. Werkzeug nach Anspruch 1 oder 2, **dadurch gekennzeichnet, daß** die einzige oder die äußere Molybdänsulfidschicht mehrlagig ist und die jeweils unterste oder untersten Lagen mit einer jeweils 200 nm nicht übersteigenden Dicke eine hexagonale Gitterstruktur mit einer Vorzugsorientierung der hexagonalen Ebenen parallel zur Werkzeugoberfläche aufweisen und/oder daß der Mo₂S₃-Anteil von innen nach außen, d.h. mit wachsendem Abstand von der Substratkörperoberfläche unterschiedlich groß ist, vorzugsweise sich periodisch von 5 bis 30 Vol.% ändert.

4. Werkzeug nach einem der Ansprüche 1 bis 3, **dadurch gekennzeichnet, daß** die Molybdänsulfidschicht aufeinanderfolgende Lagen aus im wesentlichen reinem MoS₂ und aus einem Phasengemisch aus im wesentlichen hexagonalem MoS₂ und Mo₂S₃ enthält, wobei vorzugsweise jede der einzelnen MoS₂-Lagen eine maximale Dicke von 200 nm und die Phasengemischlagen jeweils eine Dicke zwischen 200 nm und 400 nm besitzen und/oder daß in der einzigen oder der äußersten oder der vorletzten Schicht, die im wesentlichen Molybdänsulfid enthält, noch weitere metallische Phasen mit einem Volumenanteil ≤ 20 %, vorzugsweise ≤ 10 %, enthalten sind, vorzugsweise Phasen aus Molybdän und/oder Harstoffphasen wie Molybdäncarbid, Titancarbonitrid oder Chromcarbid oder daß Zwischenlagen aus Phasen der genannten Metalle oder Hartstoffe mit einer Dicke ≤ 0,3 µm vorhanden sind.

5. Werkzeug nach einem der Ansprüche 1 bis 4, **dadurch gekennzeichnet, daß** der Volumenanteil an MoS₂ in der im wesentlichen Molybdänsulfid enthaltenen Schicht zwischen 30 und 98 Vol.%, vorzugsweise zwischen 40 und 95 Vol.%, liegt und/oder daß die Dicke der im wesentlichen Molybdänsulfid enthaltenden Schicht 0,5 bis 8 µm, vorzugsweise 2 bis 4 µm, beträgt.

6. Werkzeug nach einem der Ansprüche 1 bis 5, **dadurch gekennzeichnet, daß** die äußerste Schicht einer Dicke ≤ 200 nm aus einem Metall, vorzugsweise aus einem Element der IVabis VIa-Gruppe des Periodensystemes oder aus einem Hartstoff, vorzugsweise einem Carbid, Nitrid oder Carbonitrid eines Elementes der IVa- bis VIa-Gruppe des Periodensystemes besteht und/oder daß zumindest die Molybdänsulfidschicht mittels eines CVD-Verfahrens aufgetragen worden ist.

7. Verfahren zur Herstellung einer im wesentlichen Molybdänsulfid enthaltenden Schicht nach einem der Ansprüche 1 bis 6 mittels CVD, **dadurch gekennzeichnet, daß** ein Gasgemisch aus Molybdänchlorid, Schwefelwasserstoff, einem Edelgas und Wasserstoff unter Einstellung folgender Parameter verwendet wird:
a) Temperaturen zwischen 500°C und 900°C, vorzugsweise zwischen 600°C und 850°C,
b) Drücken zwischen 0,1 kPa und 50 kPa, vorzugsweise zwischen 0,1 und 1 kPa,
c) einem Molverhältnis Schwefelwasserstoff/Molybdänchlorid zwischen 0,1 und 4, vorzugsweise zwischen 0,1 und 2 und
d) einem (H₂ und Ar)-Anteil zwischen 80 und 99 Vol.%, vorzugsweise zwischen 90 und 98 Vol.%.

8. Verfahren nach Anspruch 7, **dadurch gekennzeichnet, daß** MoCl₅ und/oder MoCl₄ verwendet werden.

9. Verfahren nach Anspruch 7 oder 8, **dadurch gekennzeichnet, daß** das Molverhältnis H₂S/MoCl₅ während der Beschichtung alternierend für jeweils gleich lange Zeiträume, in denen eines der Molverhältnisse eingestellt ist, um einen Faktor 7 bis 10 vergrößert wird, so daß bei größerem Molverhältnis reines MoS₂ und bei kleinerem Molverhältnis ein Phasengemisch aus MoS₂ und Mo₂S₃ abgeschieden wird, wobei vorzugsweise die Zeitdauer, während der durch Einstellung des Molverhältnisses im wesentlichen das Phasengemisch MoS₂/Mo₂S₃ abgeschieden wird, zwei- bis dreimal so groß ist wie die Zeitdauer, in der im wesentlichen reines MoS₂ abgeschieden wird.

10. Verfahren nach Anspruch 9, **dadurch gekennzeichnet, daß** 8 bis 12 Lagen abgeschieden werden.

## Claims

1. Tool, especially a cutting insert for machining of metal workpieces, consisting of a hard metal base body, a cermet base body, a ceramic base body or a steel base body and at least one layer deposited thereon of which the sole layer or in the case of multiple layers the outermost layer or a layer lying under the outermost layer is composed essentially of molybdenum sulphide,
**characterised in that**,
the molybdenum sulphide layer contains a mixture of the sulphide phases MoS₂ and Mo₂S₃ with an essentially random of orientation (isotropic orientation) of the phase crystals.

2. Tool according to claim 1, **characterised in that**, in the molybdenum sulphide layer still other molybdenum-containing, sulphur-containing and/or chlorine-containing phases are present.

3. Tool according to claim 1 or 2, **characterised in that**, the single molybdenum sulphide layer or the outermost molybdenum sulphide layer is multilayered and the respective lowermost layer or lowermost layers with respective thicknesses not exceeding 200 nm have a hexagonal lattice structure with a preferred orientation of the hexagonal planes parallel to the tool surface and/or the Mo₂S₃ content from the interior outwardly, i.e. with increasing distance from the substrate body surface, has different values, preferably varying periodically by 5 to 30 volume %.

4. Tool according to one of claims 1 to 3, **characterised in that**, the successive layers of the molybdenum sulphide layer consist of essentially pure MoS₂ and of a phase mixture of essentially hexagonal MoS₂ and Mo₂S₃, whereby preferably each of the individual MoS₂ layers has a maximum thickness of 200 nm and 400 nm and/or that the single layer or the outermost or next to the outermost layer which essentially comprises molybdenum sulphide, contain still further metallic phases with a volume proportion of ≤ 20 %, preferably ≤ 10 %, preferably phases of molybdenum and/or hard material phases like molybdenum carbide, titanium carbonitride or chromium carbide or that intermediate layers of phases of the mentioned metals or hard materials with a thickness ≤ 0,3 µm are provided.

5. Tool according to one of claims 1 to 4 **characterised in that**, the volume of MoS₂ in the essentially molybdenum sulphide-containing layer is between 30 and 98 volume %, preferably between 40 and 95 volume % and/or that the thickness of the essentially molybdenum sulphide-containing layer is 0,5 to 8 µm, preferably 2 to 4 µm.

6. Tool according to one of claims 1 to 5, **characterised in that**, the outermost layer has a thickness ≤ 200 nm and is composed of a metal, preferably one of the elements of groups IVa to VIa of the periodic table or of a hard material, preferably a carbide, nitride or carbonitride of an element of group IVa to VIa of the periodic table and/or that at least the molybdenum sulphide layer is applied by a CVD process.

7. Method of producing a layer consisting essentially of molybdenum sulphide according to one of claims 1 to 6 by means of CVD, **characterised in that**, a gas mixture of molybdenum chloride, hydrogen sulphide, a noble gas and hydrogen is used under the following parameters:
a) temperature between 500°C and 900°C, preferably between 600°C and 850°C,
b) pressure between 0,1 kPa and 50 kPa, preferably between 0,1 and 1 kPa,
c) a molar ratio hydrogen sulphide(molybdenum chloride between 0,1 and 4, preferably between 0,1 and 2 and
d) an (H₂ and Ar) content between 80 and 99 volume %, preferably between 90 and 98 volume %.

8. Method according to claim 7, **characterised in that**, MoCl₅ and/or MoCl₄ is used.

9. Method according to claim 7 or 8, **characterised in that**, the molar ratio H₂S/MoCl₅ is varied alternatingly for respectively equally long time intervals in which one of the mole ratios is so adjusted that it is increased by a factor of 7 to 10 so that with the increased mole ratio pure MoS₂ is deposited and that the smaller mole ratio phase mixture of MoS₂ and M₂S₃ is deposited, whereby preferably the duration over which the mole ratio is set so that essentially the phase mixture MoS₂/Mo₂S₃ is deposited is two to three times as great as the duration in which the essentially pure MoS₂ is deposited.

10. Method according to claim 9, **characterised in that** 8 to 12 layers are deposited.

## Revendications

1. Outil, en particulier insert de coupe destiné à l'usinage de matériaux métalliques, se composant d'un corps de base en métal dur, en cermet, en céramique ou en acier et d'au moins une couche déposée sur cela, dont la couche unique ou, dans le cas de plusieurs couches, la couche extérieure ou la couche située au-dessous d'une couche extérieure se compose pour l'essentiel de sulfure de molybdène,
**caractérisé par le fait**
**que** la couche en sulfure de molybdène comprend un mélange des phases de sulfure MoS₂ et Mo₂S₃ avec une orientation pour l'essentiel aléatoire (orientation isotrope) des cristaux des phases.

2. Outil selon la revendication 1, **caractérisé par le fait qu'**encore d'autre phases contenant du molybdène, du soufre et/ou du chlore sont présentes dans la couche en sulfure de molybdène.

3. Outil selon la revendication 1 ou 2, **caractérisé par le fait que** la couche unique ou la couche extérieure en sulfure de molybdène présente plusieurs couches et que la ou les couche(s) respectivement la ou bien les plus inférieure(s) avec une épaisseur qui, respectivement, ne dépasse pas 200 nm présentent une structure réticulaire hexagonale avec une orientation préférentielle des plans hexagonaux parallèle à la surface de l'outil, et/ou que la part de Mo₂S₃ est différente de l'intérieur vers l'extérieur, c'est-à-dire avec une distance croissante de la surface du corps substrat, de préférence qu'elle varie périodiquement de 5 à 30 pour-cent volumétrique.

4. Outil selon l'une des revendications 1 à 3, **caractérisé par le fait que** la couche en sulfure de molybdène comprend des couches successives de MoS₂ pour l'essentiel pur et d'un mélange de phases de MoS₂ pour l'essentiel hexagonal et de Mo₂S₃, de préférence chacune des couches individuelles en MoS₂ présentant une épaisseur maximale de 200 nm et les couches de mélange de phases présentant respectivement une épaisseur comprise entre 200 nm et 400 nm, et/ou que, dans la couche unique ou la couche extérieure ou la couche avant-dernière qui contient pour l'essentiel du sulfure de molybdène, encore d'autres phases métalliques avec une part de volume ≤ 20 %, de préférence ≤ 10 %, sont contenues, de préférence des phases en molybdène et/ou des phases de matière dure tel que le carbure de molybdène, le carbonitrure de titane ou le carbure de chrome, ou que des couches intermédiaires en phases des métaux ou matières dures mentionnés avec une épaisseur ≤ 0,3 µm sont présentes.

5. Outil selon l'une des revendications 1 à 4, **caractérisé par le fait que** la part de volume en MoS₂ dans la couche contenant pour l'essentiel du sulfure de molybdène est comprise entre 30 et 98 pour-cent volumétrique, de préférence entre 40 et 95 pour-cent volumétrique, et/ou que l'épaisseur de la couche contenant pour l'essentiel du sulfure de molybdène est comprise entre 0,5 et 8 µm, de préférence entre 2 et 4 µm.

6. Outil selon l'une des revendications 1 à 5, **caractérisé par le fait que** la couche extérieure d'une épaisseur ≤ 200 nm se compose d'un métal, de préférence d'un élément du groupe IVa à Via de la classification périodique des éléments ou d'une matière dure, de préférence d'un carbure, d'un nitrure ou d'un carbonitrure d'un élément du groupe IVa à VIa de la classification périodique des éléments, et/ou que du moins la couche de sulfure de molybdène a été appliquée au moyen d'un procédé CVD.

7. Procédé de fabrication d'une couche contenant pour l'essentiel du sulfure de molybdène selon l'une des revendications 1 à 6 au moyen du CVD, **caractérisé par le fait que** l'on utilise un mélange de gaz de chlorure de molybdène, d'acide sulfhydrique, d'un gaz rare et d'hydrogène tout en réglant les paramètres suivants :
a) des températures comprises entre 500°C et 900°C, de préférence entre 600°C et 850°C,
b) des pressions comprises entre 0,1 kPa et 50 kPa, de préférence entre 0,1 et 1 kPa,
c) un rapport molaire acide sulfhydrique/chlorure de molybdène compris entre 0,1 et 4, de préférence entre 0,1 et 2 et
d) une part (de H₂ et de Ar) comprise entre 80 et 99 pour-cent volumétrique, de préférence entre 90 et 98 pour-cent volumétrique.

8. Procédé selon la revendication 7, **caractérisé par le fait que** l'on utilise du MoCl₅ et/ou du MoCl₄.

9. Procédé selon la revendication 7 ou 8, **caractérisé par le fait que**, durant l'action de revêtir, le rapport molaire H₂S/MoCl₅ est augmenté d'un facteur 7 à 10 de manière alternante pour des intervalles de temps de durée respectivement égale dans lesquels est réglé un des rapports molaires, de sorte que, dans le cas d'un rapport molaire plus grand, du MoS₂ pur est déposé et, dans le cas d'un rapport molaire plus petit, un mélange de phases de MoS₂ et de Mo₂S₃ est déposé, de préférence la durée durant laquelle pour l'essentiel le mélange de phases MoS₂/Mo₂S₃ est déposé par un réglage du rapport molaire étant deux à trois fois plus grande que la durée dans laquelle pour l'essentiel du MoS₂ pur est déposé.

10. Procédé selon la revendication 9, **caractérisé par le fait que** 8 à 12 couches sont déposées.
